# EUROPÄISCHE PATENTSCHRIFT

(11) **EP 1 910 590 B1**
(45) Veröffentlichungstag und Bekanntmachung des Hinweises auf die Patenterteilung: **21.04.2010**
(21) Anmeldenummer: 06776582.6
(22) Anmeldetag: 03.08.2006
(51) Int. Cl.: C25D 7/06, C25D 17/00, C25D 17/06

(54) **EINRICHTUNG ZUR BEHANDLUNG VON SUBSTRATEN, INSBESONDERE ZUR GALVANISIERUNG VON SUBSTRATEN**
DEVICE FOR THE TREATMENT, PARTICULARLY GALVANIZATION, OF SUBSTRATES
DISPOSITIF POUR TRAITER DES SUBSTRATS, EN PARTICULIER POUR EFFECTUER UN DEPOT ELECTROLYTIQUE SUR UN SUBSTRAT

(30) Priorität: 03.08.2005 DE 102005038450
(43) Veröffentlichungstag der Anmeldung: 16.04.2008
(73) Patentinhaber: Gebr. Schmid GmbH + Co., 72250 Freudenstadt (DE)
(72) Erfinder: KAPPLER, Heinz, 72280 Dornstetten-Aach (DE)
(74) Vertreter: Patentanwälte Ruff, Wilhelm, Beier, Dauster & Partner
(86) Internationale Anmeldenummer: PCT/EP2006/007676
(87) Internationale Veröffentlichungsnummer: WO 2007/014778

(56) Entgegenhaltungen:
- DE-A1- 10 323 660
- US-A- 3 596 012
- US-A- 4 559 123
- US-A- 4 662 997
- US-A- 6 024 849

## Beschreibung

### Anwendungsgebiet und Stand der Technik

Die Erfindung betrifft eine Einrichtung zur Behandlung von Substraten oder flachen Gegenständen, insbesondere eine Galvanisiereinrichtung für Substrate oder zur Beschichtung von Solarmodulen, gemäß dem Oberbegriff des Anspruchs 1.

Aus der DE-A-10323660 ist eine Kontaktrolle zur elektrischen Kontaktierung an zu beschichtende Substrate beschrieben, wobei entlang ihres Außenumfangs einzelne Kontaktfelder vorgesehen sind. Diese sind entweder beweglich bzw. elastisch mit einem Rollenkörper verbunden, der insbesondere aus weichem Kunststoff besteht, oder aber elastisch mit der drehenden Welle. Dies soll vor allem die flächenmäßig ausgedehnten Kontaktfelder möglichst flächig auf den Substraten aufliegen lassen zur möglichst guten Kontaktierung.

In der US 4,559,123 ist eine Einrichtung beschrieben, um eine metallische Schicht auf einem Metallband elektrolytisch abzuscheiden. Dazu sind für eine elektrische Kontaktierung Walzen vorgesehen, die sich in starrer Anordnung um eine Welle drehen. An einer starren und unbeweglichen Platte sind Kontakte befestigt, die an der Innenseite der Walzen zur elektrischen Kontaktierung anliegen.

Es ist des weiteren bekannt, zur permanenten Kontaktierung, beispielsweise auch als Schutzelektrode, Metallräder odgl., die an ihrer Außenseite durchgehend sind, als Kontaktiermittel an zu beschichtende oder zu behandelnde Substrate anzulegen.

### Aufgabe und Lösung

Der Erfindung liegt die Aufgabe zugrunde, eine eingangs genannte Einrichtung bzw. Kontaktiermittel dafür zu schaffen, mit denen Probleme des Standes der Technik vermieden werden können und insbesondere der durch Anlage der Kontaktiermittel ausgeübte Druck auf die Substrate bei Gewährleistung der Kontaktierung gering gehalten werden kann.

Gelöst wird diese Aufgabe durch eine Einrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Es ist vorgesehen, dass die Substrate auf einer Durchlaufbahn durch eine Behandlungskammer laufen, welche ein Behandlungsmedium enthält, beispielsweise eine Elektrolytlösung. Für den Durchlauf sind Transportmittel vorgesehen, die die Substrate sowohl tragen als auch durch die Behandlungskammer transportieren. Des weiteren sind Kontaktiermittel vorgesehen, mit denen über eine Leitereinrichtung eine elektrische Kontaktierung bzw. Stromzuführung an die Substrate erfolgt. Diese Kontaktiermittel weisen eine starre oder geschlossen durchgehende Oberfläche bzw. Außenseite auf, mit der sie an den Substraten anliegen. Sie weisen auch einen im wesentlichen starren Trägerring als eine Art Innenteil auf wobei die vorgenannte Oberfläche bzw. Außenseite an dem Trägerring als separates Teil angebracht ist oder integral von ihm gebildet ist. Erfindungsgemäß weist der Trägerring eine durchgehende Innenöffnung auf. Die lichte Weite dieser Innenöffnung liegt über dem Durchmesser einer Welle, auf der ein Kontaktiermittel gehalten ist bzw. sitzt. Zusätzlich ist noch eine flexible oder durchgehende elektrische Kontaktierung von der Oberfläche bzw. der Außenseite an die Leitereinrichtung vorgesehen. Durch die größere lichte Weite der Innenöffnung weist der Trägerring eine gewisse Bewegbarkeit auf der Welle auf bzw. ist von den Substraten wegbewegbar oder kann ausweichen. So werden die kontaktierten Substrate erheblich geschont bzw. von deutlichen mechanischen Belastungen, wie sie üblicherweise durch das Anlegen einer Kontaktierrolle odgl. erfolgen, freigehalten. Um Unebenheiten oder dickere Bereiche der Substrate bei gleichzeitig aufrecht erhaltener Kontaktierung sozusagen an den Kontaktiermitteln vorbeizubringen, wird das Kontaktiermittel einfach im Ganzen wegbewegt bzw. ausgelenkt bei gleichzeitig bleibender Kontaktierung. Durch die zusätzliche flexible Kontaktierung von der Oberfläche bzw. Außenseite an die Leitereinrichtung bzw. eine Stromzuführung odgl. ist trotz der Bewegbarkeit der Kontaktiermittel auf der Welle ein sicherer elektrischer Kontakt gegeben. In weiterer Ausgestaltung der Erfindung ist es möglich, dass die Stromzuführung über die Welle bzw. zumindest über einen Abschnitt der Welle erfolgt. Dies kann beispielsweise eine Einspeisung an einem Außenende der Welle sein mit einem Abgriff im Bereich der Kontaktiermittel.

Es wird auch als im Rahmen der Erfindung liegend angesehen, den Trägerring nicht direkt auf der Welle zu lagern, sondern auf einer Verdickung oder einer zusätzlichen Manschette odgl. Wichtig für die Erfindung ist eben, dass ein Trägerring der Kontaktiermittel mit Spiel in radialer Richtung, und zwar vorteilhaft in beliebiger radialer Richtung, auf der Welle sitzt bzw. gehaltert ist. Dabei muß er nicht unbedingt in direktem Kontakt mit der Welle selber sein.

Die lichte Weite der Innenöffnung der Kontaktiermittel bzw. des Trägerrings kann mindestens 5%, vorzugsweise ca. 10%, größer sein als der Wellenquerschnitt der. Vorzugsweise weisen Innenöffnung und Welle einen gleichartigen Querschnitt auf, insbesondere jeweils kreisrund.

Der Trägerring kann hülsen-, manschetten- oder rohrartig ausgebildet sein mit einer gewissen Längsausdehnung entlang der Welle. Diese Längsausdehnung bewirkt, dass der Trägerring, abgesehen von der größeren lichten Weite und dem somit etwas losen Sitz, zwar von der Welle ausgelenkt werden kann, jedoch nicht allzu stark seitlich kippen kann. Als Maß hierfür kann beispielsweise vorgesehen sein, dass der Trägerring länger ist als der Durchmesser der Welle bzw. die lichte Weite seiner Innenöffnung. Von diesem hülsen- bzw. rohrartigen Teil des Trägerrings kann in radialer Richtung eine Art Flansch abstehen mit der Oberfläche bzw. Außenseite. Der Flansch steht dabei vorteilhaft mittig von dem Trägerring ab. Die Oberfläche bzw. Außenseite bildet besonders vorteilhaft eine Verbreiterung bzw. Abflachung des abstehenden Flansches zur Vergrößerung der kontaktierenden Fläche bei Anlage an einem Substrat. Wenn das Kontaktiermittel spiegelsymmetrisch zu einer Fläche senkrecht zur Welle und durch die Mitte der Außenseite gehend ausgebildet ist, wird bei Auflage auf einem Substrat kein Kippmoment ausgeübt und die Kontaktierung erfolgt sehr gleichmäßig.

Eine einfache Ausbildung des Kontaktiermittels kann vorsehen, dass der Trägerring zusammen mit der Oberfläche bzw. Außenseite einstückig hergestellt ist und zwar aus demselben Material, vorzugsweise aus Metall wie beispielsweise Kupfer. Hierzu können entweder verschiedene Teile zusammengesetzt sein oder aber die Kontaktiermittel aus einem einzigen Metallteil geformt sein.

Die flexible Kontaktierung an die Oberfläche bzw. Außenseite kann federnd bzw. elastisch ausgebildet sein. Insbesondere können so Bewegungen des Trägerrings bzw. der Außenseite relativ zu der Welle ausgeglichen werden, vor allem wenn es Bewegungen in radialer Richtung sind. Des weiteren können diese Bewegungen beeinflusst werden, was nachfolgend jedoch noch näher ausgeführt wird.

Erfindungsgemäß ist eine elastische bzw. federnde Halterung des Trägerrings an der Welle vorgesehen. Der Trägerring kann in einer Grundposition in etwa konzentrisch auf der Welle sitzen, wobei vor allem die Oberfläche bzw. Außenseite konzentrisch zur Welle ist. Wird der Trägerring bzw. das Kontaktiermittel aus der Grund-Position ausgelenkt, insbesondere in radialer Richtung und weg von dem Substrat, so baut die federnde Halterung eine Kraft auf, die eine Rückkehr in die Grund-Position bewirkt. Dabei ist die Grund-Position auch so ausgelegt, dass in ihr üblicherweise das Kontaktiermittel genau auf gewünschte Art und Weise ein vorbeilaufendes Substrat kontaktiert. Je nach gewünschter Anwendung bzw. gewünschter Rücklenkkraft des Kontaktiermittels kann die Größe der Federkraft an der Halterung bestimmt werden. Beispielsweise ist es auch möglich, die federnde Halterung mit der vorgenannten flexiblen Kontaktierung zusammen auszuführen bzw. die Kontaktierung über die federnde Halterung vorzunehmen, die beiden Funktionen also in einem Bauteil zu vereinigen.

In weiterer Ausgestaltung der elastischen Halterung ist es möglich, sie so auszubilden, dass sich der Trägerring in Längsrichtung der Welle aus der Grund-Position heraus ein Stück bewegen lässt. Vorteilhaft wird auch nach Längsbewegung durch die federnde Halterung eine zurücklenkende Kraft aufgebaut, insbesondere durch die gleiche Feder oder gleiche Federeinrichtung wie beim Zurücklenken nach radialer Bewegung. Damit kann also erreicht werden, dass die Oberfläche bzw. Außenseite und somit die gesamten Kontaktiermittel bewegbar an der Welle gelagert sind. Durch eine federnde Halterung werden sie aus ihrer ausgelenkten Position heraus jeweils wieder in die Grund-Position zurückgebracht. Vorteilhaft wird die Federkraft, welche eine Rückkehr in die Grund-Position bewirkt, sehr gering gewählt, so dass bei einer Unebenheit der Anpressdruck an ein zu kontaktierendes Substrat gering ist und so beispielsweise bei empfindlichen Solarmodulen aus dünnem Glas Beschädigungen vermieden werden können.

Eine solche federnde Halterung kann beispielsweise schraubenfederartig über einen Längsbereich der Welle verlaufen. Sie kann seitlich neben der Trägereinrichtung an der Welle anliegen oder mit ihr verbunden sein, beispielsweise durch mindestens einen eng anliegende Windung. In seitlicher Erstreckung auf den Trägerring zu können die Windungen größer werden und einen vorgenannten manschetten- oder rohrartigen Abschnitt des Trägerrings übergreifen zu seiner Halterung. Eine derartige federnde Halterung kann an beiden Seiten des Trägerrings vorgesehen sein und diesen so in der Grund-Position halten. Sie kann auch, wie zuvor bereits genannt, die elektrische Kontaktierung über eine Welle an den Trägerring und somit an die Kontaktiermittel bilden.

Es kann vorteilhaft vorgesehen sein, dass bei der erfindungsgemäßen Einrichtung das Behandlungsmedium ausschließlich an die Unterseite der Substrate reicht bzw. kommt. So kann die Oberseite der Substrate freigehalten werden, was zum einen bezüglich eines Kontaktierverhaltens vorteilhaft sein kann und zum anderen die Verschmutzung erheblich geringer hält. Vor allem kann im Zusammenhang damit auch vorgesehen sein, dass die Kontaktiermittel auf der Oberseite der Substrate aufliegen, also in dem vom Behandlungsmedium freien Bereich. Insbesondere liegen die Kontaktiermittel nur auf der Oberseite an. Wenn die Kontaktiermittel nicht mit dem Behandlungsmedium in Kontakt kommen, so wird vermieden, dass sich Beschichtungsmaterial auf ungewünschte Weise an den Kontaktiermitteln festsetzt. Demzufolge muß es auch nicht aufwendig entfernt werden.

In weiterer Ausgestaltung der Erfindung können unterhalb der Substrate Lichtquellen in der Behandlungskammer vorgesehen sein. Insbesondere bei der Beschichtung von Solarmodulen weisen diese den Vorteil auf, dass durch Lichteinwirkung der Beschichtungsvorgang positiv beeinflusst werden kann, wie dies dem Fachmann aus dem Stand der Technik, beispielsweise aus der EP-A-542148, bekannt ist. Die Lichtquellen können länglich bzw. als Röhren ausgebildet sein und gegebenenfalls quer zur Durchlaufbahn verlaufen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigen:
- Fig. 1: eine Draufsicht auf erfindungsgemäße Kontaktiermittel auf einer Welle in Durchlaufrichtung,
- Fig. 2: eine stark vergrößerte Darstellung der Kontaktiermittel aus Fig. 1 und
- Fig. 3: eine Galvanisiereinrichtung mit diesen Kontaktiermitteln in Seitenansicht.

### Detaillierte Beschreibung der Ausführungsbeispiele.

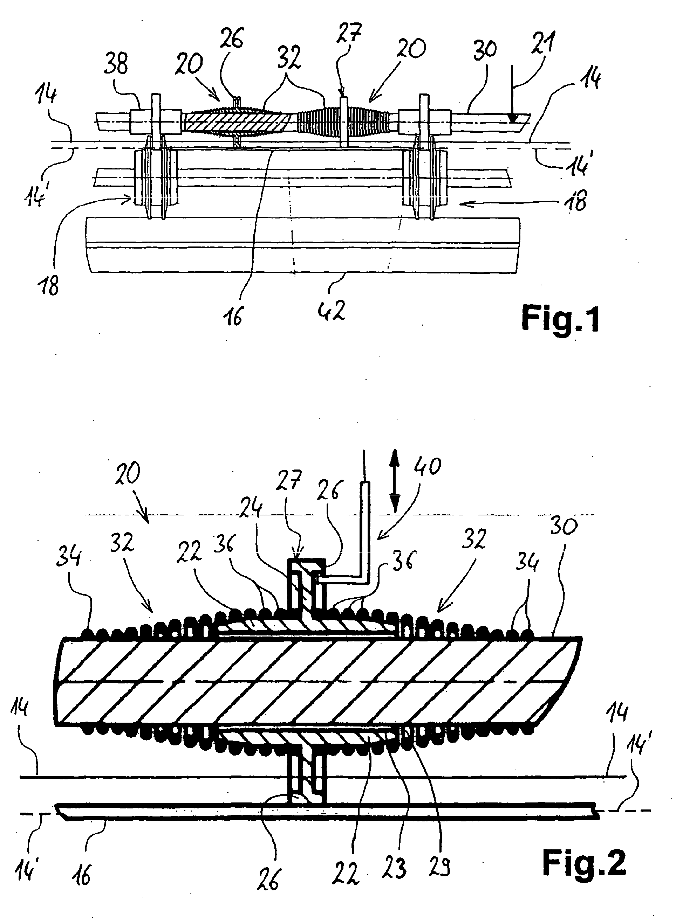

In Fig. 1 ist in Durchlaufrichtung gesehen eine Draufsicht auf Kontaktierrollen 20 als Kontaktiermittel dargestellt, die auf einer Welle 30 gelagert sind und auf der Oberseite eines Substrates 16 wie einem Solarmodul oder einer Leiterplatte aufliegen. Aus Fig. 1 ist zu erkennen, dass auf der Welle 30 zwei Kontaktierrollen 20 nebeneinander für ein Substrat 16 angeordnet sind, beispielsweise für eine an sich bekannte bessere flächige Verteilung der elektrischen Kontaktierung. Die elektrische Kontaktierung an die Welle 30, welche aus Metall oder zumindest elektrisch leitfähig ist, erfolgt über die Leiteranordnung 21. Es können auch mehrere Bahnen von Substraten 16 nebeneinander transportiert werden, unter Umständen auch unter Anpassung an ihr Format, so dass auch unterschiedliche Formate von Substraten genau angepasst bearbeitet werden können. So können für die Durchlaufbahn auch mehrere Transportrollen nebeneinander vorgesehen sein, bei denen die Substrate jeweils genau zwischen den Transportrollen liegen. So sind sie gegen seitliches Verschieben gesichert. Dabei kann die Auflage der Substrate auf den Transportrollen auch so sein, dass in diesem Bereich die Transportrollen konisch ausgebildet sind, wie es Fig. 1 entnommen werden kann. So erfolgt ein Zentrieren und gerades Ausrichten der Substrate an den Transportrollen. Der seitlich abstehende Rand der Transportrollen verhindert ein starkes Verschieben der Substrate.

Die genaue Ausbildung der Kontaktierrollen 20 ist aus der starken Vergrößerung in Fig. 2 zu erkennen. Eine Kontaktierrolle 20 weist eine Hülse 22 als vorgenannten manschetten- bzw. rohrartigen Teil. In dieser Hülse 22 befindet sich eine Innenöffnung 23, durch welche die Welle 30 verläuft. Da die lichte Weite der Innenöffnung 23 deutlich über derjenigen der Welle 30 liegt, bildet sich der Zwischenraum 29. Innenöffnung 23 und Welle 30 sind jeweils kreisrund, so dass die Hülse 22 der Kontaktierrolle 20 um das Maß des Zwischenraums 29 beispielsweise nach oben oder nach unten bewegt werden kann im Fall von Unebenheiten auf dem Substrat 16. Dies wird nachfolgend noch näher erläutert.

Vom Mittelbereich der Hülse 22 steht in etwa rechtwinklig ein Flansch 24 ab. Er geht außen in den Außenring 26 über mit einer verbreiterten und flachen Außenseite 27. Wie aus Fig. 2 zu erkennen ist, ist hier die Kontaktierrolle 20 einstückig ausgebildet, beispielsweise aus Metall wie Kupfer. Durch die Länge der Hülse 22 wird ein allzu starkes Verkippen der Kontaktierrolle 20 an der Welle 30 verhindert. Durch die an sich schmale bzw. dünnwandige Ausbildung von Hülse 22, Flansch 24 und Außenring 26 kann bei Gewährleistung der Verkippsicherheit sowie einer einigermaßen breiten Kontaktierfläche durch die Außenseite 27 ein leichtgewichtiger Aufbau erreicht werden. Dies ist vor allem deswegen von Bedeutung, weil die Gewichtskraft der Kontaktierrolle 20 eine Rolle spielt bei der Kraft, mit der sie auf der Oberseite des Substrates 16 aufliegt.

Beide Enden der Hülse 22 werden von Schraubenfedern 32 übergriffen. Die Schraubenfedern 32 liegen jeweils mit einem entfernten engen Ende 34 direkt auf der Welle 30 auf, vorteilhaft unter kraft- und reibschlüssiger, unverrückbarer Verbindung. Diese Verbindung kann durch eine Nut in der Welle 30 noch verbessert werden. Zur Kontaktierrolle 20 bzw. zum Flansch 24 hin werden die Windungen der Schraubenfedern 32 weiter und übergreifen die Außenbereiche der Hülse 22. Diese kann, wie dargestellt, an ihrer Außenseite abgeflacht sein, um einen kontinuierlichen Anstieg der Weite der Windungen der Schraubenfedern 32 zu ermögliche. Mit einem weiten Ende 36 liegen Windungen der Schraubenfedern 32 direkt auf der Hülse 22 auf, und zwar sehr nahe an dem Flansch 24. Die Windungen der Schraubenfedern 32 am weiten Ende 36 können ebenfalls so ausgebildet sein, dass sie kraft- und reibschlüssig auf der Hülse 22 aufsitzen, unter Umständen wieder verbessert durch eine eingefräste Nut odgl.

Die federnde Halterung der Kontaktierrolle 20 auf der Welle 30 durch die Schraubenfedern 32 bewirkt zum einen, dass die Kontaktierrolle bei Auslenkung nach oben nicht nur durch ihre Gewichtskraft wieder nach unten zur Anlage an die Substrate 16 gebracht wird, sondern auch durch die Federkraft. So kann verhindert werden, dass beispielsweise beim Anlauf einer Kante eines Substrates 16 die Kontaktierrolle 20 nach oben springt mit kurzzeitiger Unterbrechung der elektrischen Kontaktierung und stets angedrückt bleibt. Dabei ist diese Andruckkraft relativ gering, um empfindliche Substrate zu schonen. Des weiteren wird durch die federnde Halterung die Kontaktierrolle 20 gegen Verschiebung in Längsrichtung gesichert, wobei eine gewisse Bewegbarkeit gegeben ist. Allerdings wird die Kontaktierrolle 20 nach einer Auslenkung stets durch die Schraubenfedern 32 in die in Fig. 2 dargestellte Grundposition zurückgedrückt. Zusätzlich übernehmen die Schraubenfedern 32 die Aufgabe der elektrischen Kontaktierung der Kontaktierrolle 20 an die Welle 30 und hier wiederum an die Leiteranordnung 21 und die Stromquelle 13.

Sollte bei einer ähnlichen Kontaktiereinrichtung bzw. Galvanisiereinrichtung eine größere Bewegbarkeit der Kontaktierrolle auf der Welle 30 gefordert sein, so könnte die Innenöffnung 23 bzw. der Zwischenraum 29 vergrößert werden. Des weiteren ist es vorstellbar, dass anstelle außen anliegender Schraubenfedern 32 eine Federeinrichtung in der Innenöffnung 23 angeordnet ist, beispielsweise mit radial federnder Wirkung, wobei es auch eine Art sehr elastischer Schaumstoff odgl. sein könnte. Ein solcher Schaumstoff könnte als weitere Hülle bzw. schlauchförmig zwischen Welle 30 und Innenöffnung 23 eingebracht werden. Die elektrische Kontaktierung erfolgt dann beispielsweise entweder wiederum über eine dargestellte Schraubenfeder oder eine elektrische Leitfähigkeit des Schaumstoffs oder einen frei angeschlossenen Leiter zwischen Kontaktierrolle 20 und Welle 30 oder Leiteranordnung 21.

Neben dem Ausgleich von Unebenheiten auf dem Substrat 16 dient die Bewegbarkeit der Kontaktierrollen 20 gegenüber der Welle 30 auch noch dazu, sie über eine dargestellte Verfahreinrichtung 40 abzuheben. Diese greift mit einem hakenartigen Abschnitt zumindest von einer Seite, vorzugsweise mit zwei Haken gegenüberliegend von beiden Seiten, unter den Außenring 26 und kann ein zwangsweises Abheben der Kontaktierrolle 20 von dem Substrat 16 bewirken. Dies kann beispielsweise zum Entfernen von ungewünschten Beschichtungen aus der Elektrolytlösung 14 an dem Außenring 26 durch Umkehrung der Polarität der Stromquelle 13 dienen.

Der Vorteil einer solchen bewegbar gelagerten Kontaktierrolle 20, die zwar in sich starr und massiv ist, jedoch gegenüber den Substraten nachgiebig bzw. bewegbar ist, besteht im Vergleich zu den in sich flexiblen Kontaktierrollen aus dem Stand der Technik darin, dass hier die Ausbildung der Kontaktierrolle um ein vielfaches einfacher ist. Wie zu erkennen ist, kann eine Kontaktierrolle 20 gemäß Fig. 2 relativ leicht aus einem massiven Stück herausgearbeitet oder gegossen werden. Insbesondere umfasst die Kontaktierrolle selber keine bewegbaren Teile. Die Herstellung der Schraubenfedern 32 ist ebenfalls nicht besonders aufwendig. Gleiches gilt für die Montage der beiden Teile an den Wellen 30. Da Kontaktierrollen als Verschleißteile öfters ausgetauscht werden müssen, unabhängig von ihrer Ausbildung, ist eine einfache und auch preisgünstige Herstellung der Kontaktierrollen von großer Bedeutung.

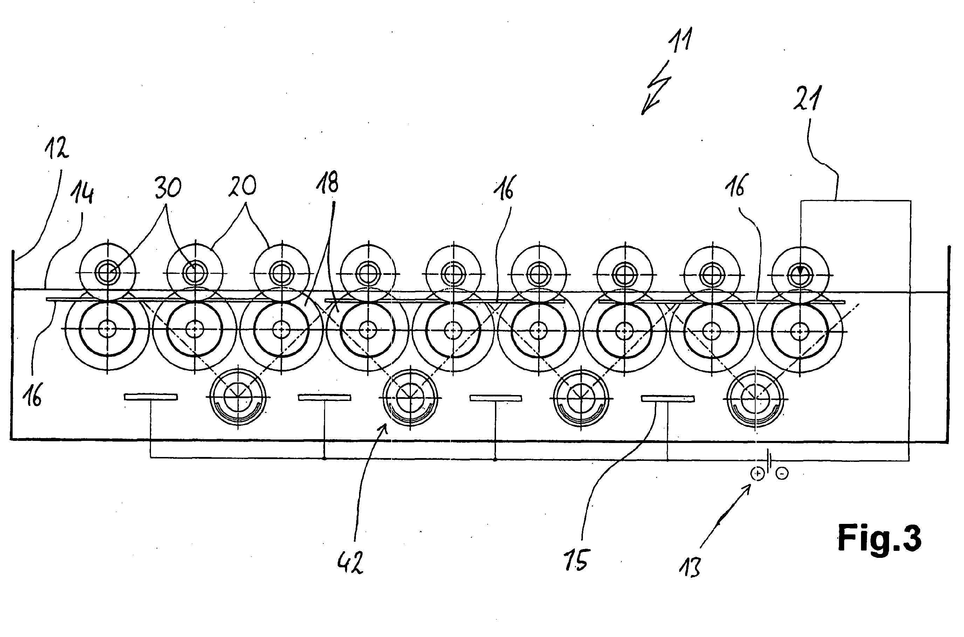

In Fig. 3 ist noch zur Verdeutlichung der Einbauart eine gesamte Galvanisiereinrichtung 11 dargestellt. Sie weist eine Behandlungskammer 12 auf mit einer Stromquelle 13, die einerseits an Elektroden 15 in der Elektrolytlösung 14 in der Behandlungskammer 12 und andererseits an die Leiteranordnung 21 angeschlossen ist. In der Behandlungskammer 12 sind unten Transportrollen 18 auf an sich bekannte Art und Weise angeordnet, auf denen die Substrate 16 aufliegen und mit denen sie transportiert werden. Auf der Oberseite der Substrate 16 liegen die Kontaktierrollen 20 an. Dabei kann vorgesehen sein, wie sowohl aus Fig. 1 als auch aus Fig. 3 zu ersehen ist, dass die Wellen 30 über Mitnahmeräder 38 an den Transportrollen 18 anliegen und über diese mitgedreht bzw. angetrieben werden. Da die Substrate 16 genau zwischen den Wellen der Transportrollen 18 einerseits und den Wellen 30 der Kontaktierräder 20 andererseits verlaufen, drehen sich Transportrollen 18 und Kontaktierräder 20 mit gleicher Geschwindigkeit. Somit ist es möglich, dass beispielsweise lediglich die Wellen der Transportrollen 18 angetrieben werden müssen.

Des weiteren sind Lichtröhren 42 unterhalb der Substrate 16 angeordnet, und zwar jeweils zwischen den Elektroden 15. Alternativ können Lichtquellen auch über den Substraten 16 angeordnet sein. Diese Lichtröhren strahlen mit strichpunktiert angegebenen Strahlungsbereichen die Unterseite der Substrate 16 an, welche in diesem Fall vorteilhaft PV- bzw. Solarmodule sind. Dadurch kann die Galvanisier-Wirkung verbessert werden durch Eigenerzeugung des Galvanisierstroms, wie dies beispielsweise aus der EP-A-542148 bekannt ist. Die Lichtquellen können in ihrer Intensität steuerbar sein, um dadurch die Abscheideraten auf Solarmodulen zu beeinflussen. Die Wellenlänge kann in einem Bereich zwischen 400 nm und 1100 nm liegen. Die Lichtquellen können alternativ zu Lichtröhren auch einzelnen Strahler sein, beispielsweise punktförmig oder rechteckig sein. Zur Verstärkung der Wirkung können auch Reflektoren vorgesehen sein. Des weiteren können die Lichtröhren für ein Eintauchen ausgerüstet sein.

Des weiteren ist vor allem aus Fig. 1 zu erkennen, wie die Substrate 16 vollständig unterhalb des Niveaus der Elektrolytlösung 14 verlaufen, also komplett eingetaucht sind. Somit verlaufen auch die Außenringe 26 der Kontaktierrollen 20 in der Elektrolytlösung 14. In anderer Ausgestaltung der Erfindung kann des Niveau der Elektrolytlösung niedriger, beispielsweise auf der gestrichelt dargestellten Höhe 14 verlaufen, so dass gerade die Unterseite der Substrate 16 benetzt wird. Dies ermöglicht es, dass die Oberseite der Substrate 16 trocken bleibt, und somit die Kontaktierrollen 20 bzw. deren Außenringe 26 frei von Elektrolytlösung.

Neben einer vorteilhaften Verwendung der Kontaktierrollen 20 zur elektrischen Verbindung an die Stromquelle 13 zur Galvanisierung der Substrate 16 können diese Kontaktierrollen dazu dienen, ein Schutzpotential an die Substrate anzulegen, beispielsweise an Solarmodulen, die als Substrate 16 durch die Anlage laufen. Eine Schutzanode kann als Opferanode ausgebildet sein. Ebenso kann dadurch Korrosion verhindert werden. Somit ist hier keine Stromquelle angeschlossen. Die Solarmodule weisen an der Rückseite eine Aluminiumschicht auf. Wenn über die Kontaktierrollen 20 diese Aluminiumschicht kontaktiert wird und über die Leiteranordnung 21 an ein Schutzpotential angelegt wird, kann die Auflösung des Aluminiums verhindert werden. In diesem Fall kann beispielsweise die vorbeschriebene Erzeugung des Galvanisierungsstroms durch die Lichtröhren 42 von besonderem Vorteil sein.

Des weiteren können Schutzanoden vorgesehen sein, die in Abstand zu den Kathoden bzw. Elektroden 15 und parallel dazu angeordnet sein können. Sie können löslich oder unlöslich ausgebildet sein. Ein Schutzpotential kann mittels der Schutzanoden, unter Umständen auch mittels der Kontaktierrollen 20, angelegt werden. Dies kann im Strippbetrieb gemacht werden, also dann, wenn unerwünschte Beschichtungen durch Umkehren der Polarität entfernt werden. Vor allem von den Kontaktierrollen 20 können dadurch unerwünschte Beschichtungen entfernt werden, wobei hier die Substrate als Gegenelektroden genutzt werden können. In einer abgehobenen Position der Kontaktierrollen ist es möglich sie als Schutzanoden zu nutzen. Des weiteren sollte für einen durchgehenden ununterbrochenen Beschichtungs-Betrieb stets eine Kontaktierrolle an einem Substrat anliegen. So können die Kontaktierrollen beispielsweise abwechselnd angehoben werden zum Entfernen der Beschichtung und abgesenkt werden zum Kontaktieren der Substrate.

Das Anlegen des Schutzpotentials kann insgesamt und auch lokal einstellbar bzw. geregelt oder gesteuert sein. Dies kann über einen oder mehrere Gleichrichter erfolgen. Unter Umständen kann dies auch für Gruppen von Kontaktierrollen oder sogar einzelne Kontaktierrollen gelten, so dass auch ein Entfernen von Beschichtungen gezielt vorgenommen werden kann, insbesondere an einzelnen Kontaktierrollen. So können andere Kontaktierrollen weiterhin die Kontaktierfunktion erfüllen.

## Patentansprüche

1. Einrichtung zur Behandlung von Substraten (16) oder flachen Gegenständen, insbesondere Galvanisiereinrichtung (11) für Substrate, auf einer Durchlaufbahn durch eine Behandlungskammer (12) mit einem Behandlungsmedium, wie eine Elektrolytlösung (14), mit Transportmitteln (18) für den Transport der Substrate durch die Behandlungskammer (12) und mit Kontaktiermitteln (20) zur elektrischen Kontaktierung bzw. Stromzuführung von einer Leitereinrichtung (21) an die Substrate, wobei die Kontaktiermittel eine starre und geschlossen durchgehende Oberfläche bzw. Außenseite (27) zur Anlage an den Substraten (16) und einen im wesentlichen starren Trägerring (22) aufweisen, wobei die Oberfläche bzw. Außenseite (27) an dem Trägerring (22) angebracht ist oder von ihm gebildet ist, wobei der Trägerring (22) eine durchgehende Innenöffnung (23) aufweist, deren lichte Weite über einem Durchmesser einer Welle (30) liegt, auf der das wenigstens eine Kontaktiermittel gehalten ist, wobei eine flexible bzw. durchgehende permanente elektrische Kontaktierung (32) von der Oberfläche bzw. Außenseite (27) an die Leitereinrichtung (21) vorgesehen ist, **gekennzeichnet durch** eine elastische bzw. federnde Halterung (32) des Trägerrings (22) an der Welle (30).

2. Einrichtung nach Anspruch 1, **dadurch gekennzeichnet, dass** die Kontaktierung (32) an die Welle (30) geht.

3. Einrichtung nach Anspruch 1 oder 2, **dadurch gekennzeichnet, dass** die lichte Weite um mindestens 5%, vorzugsweise ca. 10%, größer ist als der Durchmesser der Welle (30), wobei vorzugsweise Innenöffnung (23) und Welle (30) einen gleichartigen bzw. den gleichen Querschnitt aufweisen.

4. Einrichtung nach einem der vorhergehenden Ansprüche, **dadurch gekennzeichnet, dass** der Trägerring (22) hülsenartig bzw. rohrartig ausgebildet ist in einer Längsausdehnung entlang der Welle (30), wobei vorzugsweise seine Länge größer ist als der Durchmesser der Welle.

5. Einrichtung nach Anspruch 4, **dadurch gekennzeichnet, dass** von dem Trägerring (22) in radialer Richtung nach Art eines Flansches (24) die Oberfläche bzw. Außenseite (27) des Kontaktiermittels (20) absteht, insbesondere mittig, wobei vorzugsweise an der Oberfläche bzw. Außenseite eine Verbreiterung (26) und/oder Abflachung vorgesehen ist.

6. Einrichtung nach einem der vorhergehenden Ansprüche, **dadurch gekennzeichnet, dass** der Trägerring (22) zusammen mit der Oberfläche bzw. Außenseite (27) einstückig aus demselben Material hergestellt ist, insbesondere aus Metall.

7. Einrichtung nach einem der vorhergehenden Ansprüche, **dadurch gekennzeichnet, dass** die flexible Kontaktierung (32) federnd ausgebildet ist, insbesondere zum Ausgleich von Bewegungen des Trägerrings (22) relativ zu der Welle (30), vorzugsweise zum Ausgleich von Bewegungen in radialer Richtung.

8. Einrichtung nach einem der vorhergehenden Ansprüche, **dadurch gekennzeichnet, dass** der Trägerring an der Welle eine Grund-Position aufweist, in der er etwa konzentrisch auf der Welle sitzt, wobei die Halterung (32) bei Auslenkung des Trägerrings (22) aus der Grund-Position eine zurücklenkende Kraft bzw. Federkraft aufbaut.

9. Einrichtung nach Anspruch 1 oder 8, **dadurch gekennzeichnet, dass** die Halterung (32) eine Bewegung des Trägerrings (22) in Längsrichtung der Welle (30) aus der Grundposition an einer bestimmten Längs-Stelle der Welle heraus zulässt, wobei vorzugsweise die Halterung (32) beim Verlassen der Grundposition eine entgegenwirkende Kraft bzw. Federkraft aufbaut zur Rückkehr in die Grundposition.

10. Einrichtung nach Anspruch 1 oder 8 oder 9, **dadurch gekennzeichnet, dass** die Halterung (32) schraubenfederartig über einen Längsbereich der Welle (30) verläuft, wobei sie seitlich neben dem Trägerring (22) an der Welle (30) anliegt oder mit dieser verbunden ist mit mindestens einer umlaufenden Windung (34) und in seitlicher Erstreckung zunehmend größere Windungen (36) aufweist, welche hülsenartige oder rohrartige Abschnitte des Trägerrings (30) halternd übergreifen.

11. Einrichtung nach Anspruch 10, **dadurch gekennzeichnet, dass** zwei solcher Schraubenfedern (32) von beiden Enden des rohrartigen oder manschettenartigen Teils des Trägerrings (22) jeweils voneinander weg bis zu der Welle (30) reichen und mit dieser verbunden bzw. daran befestigt sind.

12. Einrichtung nach Anspruch 7 und 8 und einem der Ansprüche 9 bis 11, **dadurch gekennzeichnet, dass** die flexible Kontaktierung (32) die Halterung bildet.

13. Einrichtung nach einem der vorhergehenden Ansprüche, **dadurch gekennzeichnet, dass** an dem Kontaktiermittel (20), insbesondere an der Außenseite (27), eine Verfahreinrichtung (40) angreift zum Wegbewegen des Kontaktiermittels von der Oberfläche der Substrate (16), vorzugsweise mit permanentem Eingriff.

14. Einrichtung nach einem der vorhergehenden Ansprüche, **dadurch gekennzeichnet, dass** beim Durchlauf der Substrate (16) auf der Durchaufbahn ausschließlich deren Unterseite mit dem Behandlungsmedium (14) in Berührung kommt.

15. Einrichtung nach einem der vorhergehenden Ansprüche, insbesondere nach Anspruch 14, **dadurch gekennzeichnet, dass** die Kontaktiermittel (20) auf der Oberseite der Substrate (16) aufliegen, vorzugsweise nur auf der Oberseite.

16. Einrichtung nach einem der vorhergehenden Ansprüche, **dadurch gekennzeichnet, dass** unterhalb der Substrate (16) Lichtquellen (42) angeordnet sind, vorzugsweise innerhalb des Behandlungsmediums (14), wobei insbesondere die Lichtquellen (42) länglich bzw. als Röhren ausgebildet sind und gegebenenfalls quer zur Durchlaufbahn verlaufen.

## Claims

1. Device for the treatment of substrates (16) or flat articles, particularly a galvanizing device (11) for substrates, on a passage path through a treatment chamber (12) with a treatment medium, such as an electrolytic solution (14), with conveying means (18) for conveying the substrates through the treatment chamber (12) and with contacting means (20) for the electrical contacting or power supply from a conductor device (21) to the substrates, the contacting means having a rigid, closed continuous surface or outside (27) for engagement on the substrates (16) and a substantially rigid carrier ring (22), the surface or outside (27) being fitted to or being formed by the carrier ring (22), the carrier ring (22) having a through inner opening (23), whose inside diameter is greater than the diameter of a shaft (30) on which is held the at least one contacting means, wherein a flexible or continuous, permanent electrical contacting (32) of the surface or outside (27) on the conductor device (21) is provided, **characterized by** an elastic or resilient holder (32) of the carrier ring (22) on the shaft (30).

2. Device according to claim 1, **characterized in that** contacting (32) is on the shaft (30).

3. Device according to claim 1 or 2, **characterized in that** the inside diameter is at least 5%, preferably approximately 10% larger than the diameter of the shaft (30) and preferably the inner opening (23) and the shaft (30) have a similar or the same cross-section.

4. Device according to one of the preceding claims, **characterized in that** the carrier ring (22) is sleeve-like or tubular in a longitudinal extension along the shaft (30) and preferably its length exceeds the shaft diameter.

5. Device according to claim 4, **characterized in that** the surface or outside (27) of contacting means (20) projects radially in the manner of a flange (24) from the carrier ring (22) and in particular in a central manner and preferably a widening (26) and/or flattening is provided on the surface or outside.

6. Device according to one of the preceding claims, **characterized in that** the carrier ring (22) together with the surface or outside (27) is made integrally from the same material, particularly metal.

7. Device according to one of the preceding claims, **characterized in that** the flexible contacting (32) has a resilient construction, particularly for compensating movements of the carrier ring (22) relative to the shaft (30), preferably for compensating radial movements.

8. Device according to one of the preceding claims, **characterized in that** the carrier ring has on the shaft a normal position in which it is seated roughly in concentricity on the shaft and on deflecting the carrier ring (22) from the normal position, the holder (32) builds up a back-guiding force or resilience.

9. Device according to claim 1 or claim 8, **characterized in that** the holder (32) allows a movement of the carrier ring (22) in the longitudinal direction of the shaft (30) from the normal position to a given longitudinal point of the shaft and preferably on leaving the normal position the holder (32) builds up a counteracting force or resilience for return to the normal position.

10. Device according to claim 1 or claim 8 or claim 9, **characterized in that** the holder (32) runs in helical screw-like manner over a longitudinal part of the shaft (30) and engages with or is connected laterally alongside the carrier ring (22) to the shaft (30) with at least one circumferential turn (34) and has increasingly larger turns (36) in the lateral extension and they engage in holding manner over sleeve-like or tubular sections of the carrier ring (22).

11. Device according to claim 10, **characterized in that** two such helical springs (32) extend from both ends of the tubular or collar-like part of the carrier ring (22) away from one another up to the shaft (30) and are connected or fixed to the latter.

12. Device according to claims 7 and 8 and one of the claims 9 to 11, **characterized in that** the flexible contacting (32) forms the holder.

13. Device according to one of the preceding claims, **characterized in that** on the contacting means (20), particularly on the outside (27), engages a displacement device (40) for moving the contacting means away from the surface of the substrates (16), preferably with permanent engagement.

14. Device according to one of the preceding claims, **characterized in that** during the passage of the substrates (16) on the passage path only the underside thereof comes into contact with the treatment medium (14).

15. Device according to one of the preceding claims, particularly according to claim 14, **characterized in that** the contacting means (20) rest on the top of the substrates (16) and preferably only on said top side.

16. Device according to one of the preceding claims, **characterized in that** light sources (42) are placed below the substrates (16) and preferably within the treatment medium (14) and in particular the light sources (42) are elongated or in the form of tubes and optionally run transversely to the passage path.

## Revendications

1. Dispositif pour le traitement de substrats (16) ou d'objets plats, notamment dispositif de galvanisation (11) pour substrats sur un parcours de cheminement à travers une chambre de traitement (12), avec une substance de traitement, telle qu'un électrolyte (14), avec des moyens de transport (18) pour le transport de substrats à travers la chambre de traitement (12) et avec des moyens d'établissement de contact (20) pour l'établissement de contacts électriques ou encore pour l'amenée de courant à partir d'un organe de conduction (21) aux substrats, sachant que les moyens d'établissement de contact (20) présentent une surface ou encore une face extérieure (27) rigide et intégralement continue pour le contact mécanique avec les substrats (16) et un anneau de support (22) essentiellement rigide, sachant que la surface ou encore la face extérieure (27) est appliquée sur l'anneau de support (22) ou bien elle est constituée par celui-ci, sachant que l'anneau de support (22) présente une ouverture intérieure (23) qui s'étend de bout en bout, dont le diamètre intérieur est supérieur au diamètre d'un arbre (30), sur lequel est retenu le ou les moyens d'établissement de contact, sachant qu'on prévoit une connexion électrique (32) flexible ou encore continue et permanente à partir de la surface ou encore de la face extérieure (27) au moyen de conduction (21), **caractérisé par** un moyen de retenue (32) élastique ou encore à ressort gardant l'anneau de support (22) sur l'arbre (30).

2. Dispositif d'après la revendication 1, **caractérisé en ce que** la connexion électrique (32) s'étend jusqu'à être adjacente à l'arbre (30).

3. Dispositif d'après la revendication 1 ou 2, **caractérisé en ce que** le diamètre intérieur est supérieur au diamètre de l'arbre (30) d'au moins 5%, de préférence de 10%, sachant que de préférence l'ouverture intérieure (23) et l'arbre (30) présentent une section transversale similaire ou encore identique.

4. Dispositif d'après une des revendications précédentes, **caractérisé en ce que** l'anneau de support (22) est réalisé à la manière d'une douille ou encore d'un tube, présentant une étendue longitudinale le long de l'arbre (30), sachant que de préférence sa longueur est plus grande que le diamètre de l'arbre.

5. Dispositif d'après la revendication 4, **caractérisé en ce que** la surface ou encore la face extérieure (27) du moyen d'établissement de contact (20) saille de l'anneau de support (22) en direction radiale à la manière d'une bride (24), notamment de façon centrée, sachant qu'on prévoit de préférence à la surface ou encore à la face extérieure un élargissement (26) et/ou un aplatissement.

6. Dispositif d'après une des revendications précédentes, **caractérisé en ce que** l'anneau de support (22) est fabriqué d'une seule pièce avec la surface ou encore la face extérieure (27) d'un même matériau, notamment en métal.

7. Dispositif d'après une des revendications précédentes, **caractérisé en ce que** la connexion électrique (32) flexible est réalisée de manière élastique à ressort, notamment pour compenser des mouvements relatifs de l'anneau de support (22) par rapport à l'arbre (30), de préférence pour compenser des mouvements en direction radiale.

8. Dispositif d'après une des revendications précédentes, **caractérisé en ce que** l'anneau de support sur l'arbre présente une position de base, dans laquelle il est à peu près concentrique par rapport à l'arbre, sachant que le moyen de retenue (32) constitue une force de rappel ou encore une résilience quand l'anneau de support (22) est déplacé de sa position de base.

9. Dispositif d'après la revendication 1 ou 8, **caractérisé en ce que** le moyen de retenue (32) permet un mouvement de l'anneau de support (22) en direction longitudinale de l'arbre (30) à partir de la position de base dans une certaine position longitudinale de l'arbre, sachant que de préférence quand le moyen de retenue (32) abandonne la position de base, il constitue une force de rappel ou encore une résilience pour y revenir.

10. Dispositif d'après la revendication 1 ou 8 ou 9, **caractérisé en ce que** le moyen de retenue (32) s'étend à la manière d'un ressort en spirale sur un champ longitudinal de l'arbre (30), sachant qu'il est adjacent à l'arbre (30) latéralement à côté de l'anneau de support (22) ou bien qu'il est raccordé à celui-ci par au moins une spire (34) complète et qu'il présente latéralement des spires (36) de plus en plus grandes, qui s'engagent en le retenant au-dessus de parties de l'anneau de support (22) et présentant une forme de douille ou de tube.

11. Dispositif d'après la revendication 10, **caractérisé en ce que** deux de ces ressorts en spirale (32) s'étendent respectivement à partir des deux extrémités de la partie tubulaire ou en manchette de l'anneau de support (22) en s'éloignant l'un de l'autre jusqu'à l'arbre (30), où ils sont raccordés ou encore fixés à celui-ci.

12. Dispositif d'après la revendication 7 ou 8 e une des revendications de 9 à 11, **caractérisé en ce que** la connexion électrique (32) flexible constitue le moyen de retenue (32).

13. Dispositif d'après une des revendications précédentes, **caractérisé en ce qu'**un moyen de déplacement (40) s'engage auprès du moyen d'établissement de contact (20), de préférence à la face extérieure (27) pour déplacer le moyen d'établissement de contact de la surface des substrats (16), l'engagement étant de préférence permanent.

14. Dispositif d'après une des revendications précédentes, **caractérisé en ce que** pendant le passage des substrats (16) sur le parcours de cheminement, uniquement leur face inférieure se met en contact avec la substance de traitement (14).

15. Dispositif d'après une des revendications précédentes, notamment d'après la revendication 14, **caractérisé en ce que** les moyens d'établissement de contact (20) sont posés sur la face supérieure des substrats (16), de préférence uniquement sur la face supérieure.

16. Dispositif d'après une des revendications précédentes, **caractérisé en ce que** des sources lumineuses (42) sont disposés au-dessous des substrats (16), de préférence dans la substance de traitement (14), sachant que notamment les sources lumineuses (42) s'étendent de manière oblongue ou encore sont réalisées sous forme tubulaire et s'étendent éventuellement transversalement par rapport au parcours de cheminement.
